# FASCICULE DE BREVET EUROPEEN

(11) **EP 2 498 309 B1**
(45) Date de publication et mention de la délivrance du brevet: **05.07.2017**
(21) Numéro de dépôt: 12155106.3
(22) Date de dépôt: 13.02.2012
(51) Int. Cl.: H01L 35/30, F28D 7/00

(54) **Module et dispositif thermo électrique, notamment destiné à générer un courant électrique dans un véhicule automobile**
Modul und thermoelektrische Vorrichtung, insbesondere zur Stromerzeugung in einem Kraftfahrzeug
Thermoelectric module and device, in particular intended for generating an electric current in an automobile

(30) Priorité: 10.03.2011 FR 1151991
(43) Date de publication de la demande: 12.09.2012
(73) Titulaire: VALEO SYSTEMES THERMIQUES, 78320 Le Mesnil Saint-Denis (FR)
(72) Inventeur: Monnet, Véronique, 53810 CHANGE (FR); Gille, Gérard, 53270 Thorigné-en-Charnie (FR); Boiselle, Patrick, 53000 Laval (FR)
(74) Mandataire: Neuviale, Bertrand

(56) Documents cités:
- WO-A1-2007/026432
- DE-A1-102007 063 173
- US-A1- 2004 206 386

## Description

La présente invention concerne un module et un dispositif thermo électrique, notamment destiné à générer un courant électrique dans un véhicule automobile.

Il a déjà été proposé des dispositifs thermo électriques utilisant des éléments, dits thermo électriques, permettant de générer un courant électrique en présence d'un gradient de température entre deux de leurs faces opposées selon le phénomène connu sous le nom d'effet Seebeck. Ces dispositifs comprennent un empilement de premiers tubes, destinés à la circulation des gaz d'échappement d'un moteur, et de seconds tubes, destinés à la circulation d'un fluide caloporteur d'un circuit de refroidissement. Les éléments thermo électriques sont pris en sandwich entre les tubes de façon à être soumis à un gradient de température provenant de la différence de température entre les gaz d'échappement, chauds, et le fluide de refroidissement, froid.

Des tels dispositifs sont particulièrement intéressants car ils permettent de produire de l'électricité à partir d'une conversion de la chaleur provenant des gaz d'échappement du moteur. Ils offrent ainsi la possibilité de réduire la consommation en carburant du véhicule en venant se substituer, au moins partiellement, à l'alternateur habituellement prévu dans celui-ci pour générer de l'électricité à partir d'une courroie entrainée par le vilebrequin du moteur.

DE 10 2007 063173 A1 décrit un module thermo électrique comportant une pluralité de rangs de circulation d'un premier fluide et une pluralité de rangs de circulation d'un second fluide. Une contrainte rencontrée avec les dispositifs connus est qu'ils nécessitent qu'un très bon contact soit assuré entre les éléments thermo électriques et les tubes de manière à assurer une conduction satisfaisante entre eux. Il faut ainsi disposer de tubes présentant une parfaite planéité et un excellent état de surface impactant le coût de revient du dispositif.

Plus la puissance électrique à fournir est forte, plus le nombre de tubes à empiler doit être grand et/ou plus la surface des tubes à employer doit être large, compliquant encore la bonne application des éléments thermo électriques sur les tubes.

Une première solution, consistant à renforcer le contact grâce à des composants externes exerçant un effort de compression sur l'empilement de tubes, a été testée. Cette solution nécessite cependant d'utiliser des tubes ne risquant pas de s'écraser sur eux-mêmes sous l'effet de cet effort, conduisant à une surconsommation de matière. La qualité du contact assuré reste en outre insuffisante, notamment en raison de la disparité de dimension des éléments thermo électriques.

L'invention selon la revendication 1 vise à améliorer la situation en proposant un module thermo électrique comprenant une pluralité de tubes de circulation d'un premier fluide, s'étendant parallèlement les uns aux autres, en un rang, et une pluralité de tubes de circulation d'un second fluide s'étendant parallèlement les uns aux autres, en deux rangs, situés de part et d'autre du rang de tubes de circulation du premier fluide, ledit module comprenant en outre une pluralité d'éléments, dits thermo électriques, permettant de créer un courant électrique à partir d'un gradient de température appliqué entre deux de leurs faces, dites faces de contact, prévues au contact desdits tubes, et des moyens de compression prenant appui sur chacun des rangs de tubes de circulation du second fluide pour les appliquer en direction du rang de tubes de circulation du premier fluide.

En appliquant, grâce à la structure par module, un effort de serrage propre à chaque rang de circulation du premier fluide on dispose d'un effort de serrage mieux réparti et on facilite la prise en compte des dispersions de dimension des éléments thermo électriques. On améliore de la sorte le contact entre chacun de ceux-ci et les tubes contre lesquels ils sont appliqués, avec des efforts de serrage moins importants.

Selon un aspect de l'invention, lesdits moyens de compression pourront aussi être configurés pour permettre le maintien mécanique des différents composants du module.

Selon un autre aspect de l'invention, lequel les tubes de circulation du premier fluide sont configurés pour la circulation d'un fluide, dit chaud, et les tubes de circulation du second fluide sont configurés pour la circulation d'un fluide, dit froid, présentant une température inférieure à la température du second fluide. On dispose ainsi d'une solution exploitant au mieux les calories apportées par les tubes de circulation du fluide chaud.

Selon un autre aspect de l'invention, les tubes de circulation du premier fluide s'étendent longitudinalement dans une direction sécante, notamment orthogonale, à la direction dans laquelle les tubes de circulation du second fluide s'étendent longitudinalement de façon à définir des zones d'intersection des tubes, au niveau desquelles lesdits éléments thermo électriques sont prévus.

En subdivisant ainsi le trajet de circulation des fluides en plusieurs tubes se croisant, on segmente les surfaces de contact en vis-à-vis des éléments thermo électriques et on rend possible l'exercice d'une force de compression des éléments thermo électrique sur les tubes encore mieux répartie.

Dans chaque rang, lesdits tubes de circulation sont, par exemple, distants les uns des autres selon une direction orthogonale à leur direction d'extension. Lesdits éléments thermo électriques pourront être répartis par groupe distants les uns des autres selon ladite direction d'extension des tubes de circulation.

Les moyens de compression comprennent, notamment, des tiges de serrage et les tubes de circulation du premier fluide et les tubes de circulation du second fluide sont configurés pour laisser des passages pour lesdites tiges de serrage entre lesdites zones d'intersection.

Selon cet aspect de l'invention, on assure une compression selon des points multiples et ceci au plus prés des éléments thermo électriques. On dispose de la sorte de points de serrage répartie sur l'ensemble de la surface du dispositif. Les forces de serrage unitaires pourront ainsi être plus faibles et plus homogènes, permettant un meilleur contact entre les tubes et l'intégralité des éléments thermo électriques.

Les moyens de compression pourront comprendre en outre des plaques, munis de trous de passage des tiges de serrage, lesdites tiges de serrage permettant d'appliquer les plaques contre les tubes de circulation du second fluide.

Selon d'autres aspects de l'invention, pris ensemble ou séparément :
- lesdits tubes de circulation sont plats,
- lesdits tubes de circulation présentent une pluralité de canaux de circulation du fluide,
- les tubes présentent deux faces planes parallèles opposées et les éléments thermo électriques sont au contact desdites faces planes,
- les tubes de circulation sont munis de pistes pour la conduction du courant généré par lesdits éléments thermo électriques,
- le module comprend en outre une plaque collectrice reliant une extrémité desdits tubes de circulation du premier fluide,
- le module comprend une boîte collectrice en communication de fluide avec une extrémité desdits tubes de circulation du second fluide,
- les tubes de l'un, dit premier, des rangs de tubes de circulation du second fluide sont liés aux tubes de l'autre, dit second, rang de tubes de circulation du second fluide pour permettre une circulation du second fluide en série de chacun des tubes de circulation du premier fluide du premier rang avec un des tubes de circulation du second fluide du second rang.

L'invention concerne aussi un dispositif thermo électrique, comprenant une pluralité de modules tels que décrit plus haut, superposés les uns aux autres, selon une direction, dite d'empilement.

Selon différents modes de réalisation, pris séparément ou en combinaison :
- les moyens de compressions de chacun des modules sont situés en vis-à-vis des moyens de compression des modules voisins,
- le dispositif comprend une plaque collectrice, dite commune, en communication de fluide avec les tubes de circulation du premier fluide, à l'une de leur extrémité, ladite plaque étant configurée pour assurer un accrochage des modules entre eux,
- le dispositif comprend une goulotte de raccordement de la plaque collectrice commune à des conduits de circulation du premier fluide.

L'invention sera mieux comprise à la lumière de la description suivante qui n'est donnée qu'à titre indicatif et qui n'a pas pour but de la limiter, accompagnée des dessins joints parmi lesquels :
- la figure 1 illustre en perspective, un exemple de module thermo électrique conforme à l'invention,
- la figure 2 illustre le module de la figure 1, représenté de façon éclatée,
- la figure 3 illustre en perspective, un exemple de dispositif thermo électrique conforme à l'invention, représenté de façon éclatée.

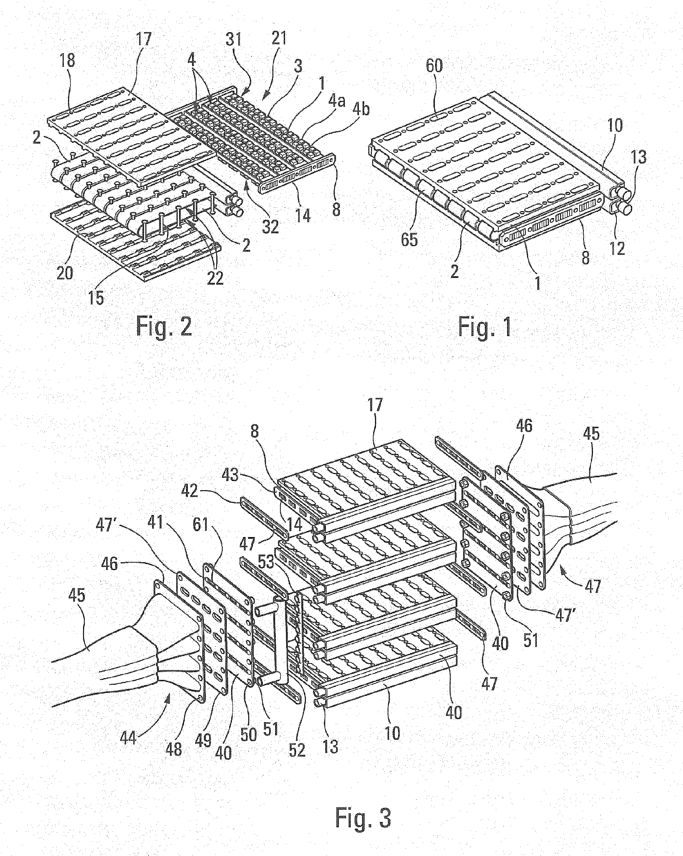

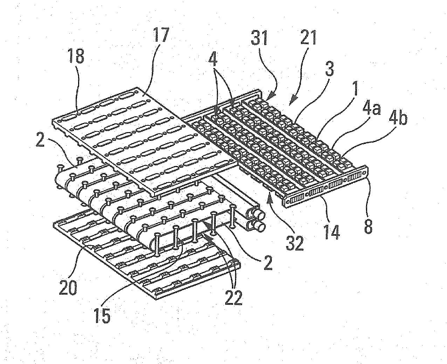

Comme illustré aux figures 1 et 2, l'invention concerne tout d'abord un module thermo électrique comprenant une pluralité de tubes 1 de circulation d'un premier fluide, s'étendant parallèlement les uns aux autres, en un rang 21, et une pluralité de tubes 2 de circulation d'un second fluide s'étendant parallèlement les uns aux autres, en deux rangs 22, situés de part et d'autre du rang 21 de tubes 1 de circulation du premier fluide.

Les tubes 1 de circulation du premier fluide sont configurés, par exemple, pour la circulation d'un fluide, dit chaud. Il pourra s'agir des gaz d'échappement d'un moteur thermique de véhicule automobile. Les tubes 2 de circulation du second fluide sont configurés, par exemple, pour la circulation d'un fluide, dit froid, présentant une température inférieure à la température du premier fluide. Il pourra s'agir d'un liquide de refroidissement, tel qu'un mélange d'eau et de glycol, provenant, par exemple, d'une boucle de refroidissement basse température du véhicule.

Les tubes de circulation 1 de gaz d'échappement sont, notamment, au nombre de trois à cinq, ici quatre, tandis que les tubes de circulation 2 du liquide de refroidissement sont, notamment, au nombre de cinq à dix, ici huit.

Ledit module comprend en outre une pluralité d'éléments 3, dits thermo électriques, permettant de créer un courant électrique à partir d'un gradient de température appliqué entre deux de leurs faces 4a, 4b, dites faces de contact, prévues au contact desdits tubes 1, 2.

Il s'agit, par exemple, d'éléments de forme sensiblement parallélépipédiques générant un courant électrique, selon l'effet Seebeck. De tels éléments permettent la création d'un courant électrique dans une charge connectée entre lesdites faces de contact 4a, 4b, prévues opposées. De façon connue de l'homme du métier, de tels éléments sont constitués, par exemple, de Bismuth et de Tellurium (Bi₂Te₃).

Les éléments thermo électriques 3 pourront être, pour une première partie, des éléments d'un premier type, dit P, permettant d'établir une différence de potentiel électrique dans un sens, dit positif, lorsqu'ils sont soumis à un gradient de température donné, et, pour l'autre partie, des éléments d'un second type, dit N, permettant la création d'une différence de potentiel électrique dans un sens opposé, dit négatif, lorsqu'ils sont soumis au même gradient de température.

Comme illustré, les éléments thermo électriques 3 sont réparties en deux nappes 31, 32, une première nappe 31 entre les tubes 1 de circulation du premier fluide et l'un 22 des rangs de tubes 2 de circulation du second fluide et un seconde nappe 32 entre les tubes 1 de circulation du premier fluide et l'autre 22 des rangs de tubes 2 de circulation du second fluide. L'une 4b de leur face de contact 3 est en contact avec les tubes 1 de circulation du premier fluide tandis que l'autre 4a de leur face de contact est en contact des tubes 2 de circulation du second fluide.

Le module conforme à l'invention comprend aussi des moyens de compression prenant appui sur chacun des rangs 22 de tubes 2 de circulation du second fluide pour les appliquer en direction du rang 21 de tubes 1 de circulation du premier fluide. On assure de la sorte une répartition des efforts de serrage permettant une bonne application des éléments thermo électriques contre chacun des tubes, même en cas d'une large dispersion de leur côtes de fabrication.

La subdivision de la circulation des fluides en plusieurs tubes permet en outre de disposer de tubes d'état de surface plus satisfaisant que dans le cas de tubes plus larges. Elle permet aussi, comme développé dans la suite, selon un exemple de réalisation de l'invention, de pouvoir exercer un effort de compression sur les tubes qui soit au plus proche des zones devant être comprimées pour assurer un bon contact avec les éléments thermo électriques 3 en s'affranchissant des déformations géométriques, notamment des phénomènes de flexions, générées par des serrages éloignés.

Les tubes de circulation du premier fluide pourront ainsi s'étendre longitudinalement, par exemple, dans une direction sécante, notamment orthogonal, à la direction dans laquelle les tubes de circulation du second fluide s'étendent longitudinalement de façon à définir des zones d'intersection des tubes 1, 2 au niveau desquelles lesdits éléments thermo électriques 3 sont prévus.

Autrement dit, on assure un flux croisé des fluides chaud et froid et on constitue des zones, réparties de façon discrète, de présence du gradient de température permettant aux éléments thermo électriques 3 de générer du courant.

Par intersection, on ne signifie pas que les tubes de circulation du premier et du second fluide se croisent puisque, en raison de leur disposition superposée, ils se trouvent dans des plans différents, mais plutôt qu'ils se chevauchent. Autrement dit, ce sont plus exactement leur projection selon leur direction de superposition qui se croise.

Lesdits éléments thermo électriques 3 sont répartis, par exemple, par groupe 4 distants les uns des autres selon ladite direction d'extension des tubes 1, 2 de circulation. Par « distants », on entend que la distance entre deux éléments thermo électriques voisins d'un même groupe 4 est très inférieure à la distance entre deux groupes 4 voisins. Les éléments thermo électriques 3 sont ici regroupés par quatre.

Les tubes 1 de circulation du premier fluide et les tubes 2 de circulation du second fluide sont configurés pour laisser des passages entre lesdites zones d'intersection et les moyens de compression comprennent, par exemple, des tiges de serrage 15 passant dans lesdits passages. Autrement dit, il est prévu une tige de serrage 15 à chaque sommet des zones d'intersection des tubes 1, 2, soit quatre tiges de serrage, formant quatre points de fixation, pour chaque zone.

On permet de la sorte un serrage réparti au niveau de chacun des groupes de thermo éléments ce qui permet d'améliorer encore le contact entre les éléments thermo électriques et les tubes pour une meilleure conduction électrique.

Les moyens de compression comprennent en outre, par exemple, des plaques 17, munis de trous 18 de passage des tiges de serrage 15. Lesdites tiges de serrage 15 sont munies d'une extrémité filetée coopérant avec lesdits trous de passage 18, prévues taraudées. Elles permettent, par serrage, d'appliquer les plaques 17 contre les tubes 2 de circulation du second fluide, directement ou indirectement.

Les plaques 17 pourront comprendre des nervures de calage 20, issues de matière, destinées à venir se positionner de part et d'autre des tubes 2 de circulation du second fluide. Elles permettent un bon alignement des trous de passage 18 d'une plaque 17 à l'autre.

Lesdites plaques 17 pourront encore comprendre des fentes 60 destinées à fragmenter les plaques 17 en surfaces d'appui multiples afin de s'accommoder au mieux des irrégularités de dimensionnement des éléments thermo électriques et d'améliorer l'efficacité du serrage provenant des points de fixation prévus à proximité des groupes d'éléments thermo électriques.

Les tubes 1, 2 sont, par exemple, munis de pistes (non illustrées) pour la conduction du courant généré par lesdits éléments thermo électriques 3. Plus précisément, ils pourront être revêtus d'une couche de matériau électriquement isolant et thermiquement conducteur, par exemple céramique, sur laquelle sont prévues lesdites pistes, notamment prévues en cuivre. Lesdites pistes relient en série et/ou en parallèle, les éléments thermo électriques 3 disposés sur les tubes. Tout ou partie des éléments de même type P ou N d'un tube 1, 2 pourront être regroupés pour être montés en parallèle tandis qu'un élément ou un groupe d'éléments de type P d'un tube sera monté en série avec un élément ou un groupe d'éléments de type N du même tube ou d'un autre tube. Autrement dit, différentes configurations de circuits électriques pourront être prévus à la surface des tubes 1, 2.

Lesdits tubes de circulation 1, 2 présentent, par exemple, une section aplatie selon une direction d'allongement, orthogonale à la direction d'extension des tubes. Lesdits tubes de circulation 1, 2 pourront ainsi être des tubes plats. On entend par là qu'ils présentent deux grandes faces parallèles reliés par des petits côtés. Lesdites pluralités de tube 1, 2 s'étendent d'ailleurs dans des plans parallèles auxdites grandes faces. Les éléments thermo électriques 3 sont au contact de l'une et/ou l'autres des faces planes des tubes 1, 2.

Lesdits tubes 1, 2 présentent, par exemple, une multiplicité de canaux. Lesdits tubes 2 destinés à la circulation du fluide froid sont constitués, par exemple, d'aluminium et/ou d'alliage d'aluminium. Ils sont, notamment, extrudés. Leurs canaux pourront être de section ronde. Les tubes 1 destinés à la circulation du fluide chaud, sont constitués, notamment, d'acier inox. Ils sont formés, par exemple, par profilage, soudage et/ou brasage. Leurs canaux de passage du fluide sont séparés, notamment, par des cloisons reliant les faces planes opposées des tubes.

Ledit module pourra en outre comprendre une plaque collectrice 8 reliant une extrémité desdits tubes 1 de circulation du premier fluide. Ladite plaque collectrice 8 est prévue, par exemple à chaque extrémité des tubes 1 de circulation du premier fluide. Elle est munie d'orifices 14 au niveau desquels les extrémités des tubes de circulation du premier fluide débouchent.

Ledit module pourra également comprendre une boîte collectrice 10 en communication de fluide avec une extrémité desdits tubes de circulation 2 du second fluide.

Lesdites boîtes collectrices 10 comprennent, par exemple, des plaques collectrices, prévues en forme de demi-cylindre, munies d'orifices accueillant les tubes de circulation du second fluide, et un couvercle de forme complémentaire, des cloisons 12 étant disposées à chaque extrémité longitudinale des boîtes 10. Des tubulures 13 d'entrée/sortie du fluide, montées sur lesdites boîtes collectrices 10, pourront également être prévues.

Comme illustré, les tubes de l'un, dit premier, des rangs de tubes 2 de circulation du second fluide sont liés aux tubes de l'autre, dit second, rang de tubes 2 de circulation du second fluide pour permettre une circulation du second fluide en série de chacun des tubes 2 de circulation du second fluide du premier rang avec un des tubes 2 de circulation du second fluide du second rang.

Les tubes 2 de circulation du second fluide sont, par exemple, identique et les tubes liés d'un rang à l'autre sont superposés, deux à deux. Ils pourront être reliés par une portion coudée 65 et définir un tube unique, en épingle.

Comme illustré à la figure 3, l'invention concerne également un dispositif thermo électrique, comprenant une pluralité de modules tels que décrits plus haut, superposés les uns aux autres, selon une direction, dite d'empilement. Ainsi les moyens de serrage sont propres à chaque module.

Ladite direction d'empilement est ici à la fois orthogonale à la direction d'extension des tubes 1 de circulation de fluide chaud et des tubes 2 de circulation du fluide froid.

Des connecteurs électriques, non illustrés, reliés aux circuits électriques desdits modules, sont prévus pour une connexion du dispositif à un réseau électrique qu'il contribuera à alimenter.

Les moyens de compressions de chacun des modules sont situés en vis-à-vis des moyens de compression des modules voisins. Dans l'exemple illustré, les plaques 17 de chacun des modules sont en vis-à-vis, éventuellement au contact, des plaques 17 des modules voisins.

Ledit dispositif comprend, par exemple, une plaque collectrice 40, dite commune, en communication de fluide avec les tubes 1 de circulation du premier fluide, à l'une de leur extrémité. Il pourra être prévu une telle plaque collectrice commune 40 à chacune des extrémités du dispositif. Ladite plaque collectrice commune 40 est munie d'orifices 61 venant en correspondance des orifices 14 des plaques collectrices 8 des modules. Ladite plaque collectrice commune 40 pourra être configurée comme étant l'élément de liaison entre les modules de sorte à éviter l'emploie des moyens spécifiques d'accrochage des modules entre eux. Autrement dit, les modules sont reliés les uns aux autres uniquement par l'intermédiaire de la plaque collectrice commune 40.

Un premier joint haute température 47, par exemple en graphite, est prévu entre la plaque commune 40 et les plaques collectrices 8 des modules.

Pour l'accrochage des modules, le dispositif conforme à l'invention comprend, notamment, des vis (non représentée), configurées pour prendre appui sur ladite plaque collectrice commune 40 au niveau d'orifices 41, traverser les premiers joints haute température 47, au niveau d'orifices 42, et coopérer avec des orifices taraudés 43, prévus dans les plaques collectrices 8 des modules.

Le dispositif comprend en outre, par exemple, une goulotte 44 de raccordement de la plaque collectrice du dispositif à un conduit 45 de circulation du premier fluide. Ladite goulotte 44, comprend une plaque 46 de raccordement à la plaque collectrice commune 40. Ladite plaque 46 de raccordement débouche en direction des orifices 61 de la plaque collectrice commune 40, communiquant avec l'extrémité des tubes.

Un second joint haute température 47', par exemple en graphite, est prévu entre la plaque de raccordement 46 et la plaque collectrice commune 40.

Pour l'accrochage de la goulotte sur la plaque collectrice commune 40, le dispositif conforme à l'invention comprend, notamment, des vis (non représentées) coopérant avec des écrous 51, lesdites vis étant configurées pour prendre appui sur ladite plaque de raccordement 46 au niveau d'orifices 48, traverser le second joint haute température 47', au niveau d'orifices 49, et traverser ladite plaque collectrice commune au niveau d'orifices 50. Lesdits écrous 51 prennent appui sur ladite plaque collectrice commune 40 au niveau d'une de ces faces opposée à la face sur laquelle prennent appui les vis pour l'accrochage des modules.

Selon une variante non illustrée, le dispositif pourra comprendre un couvercle coopérant avec la plaque collectrice commune pour définir une boîte d'entrée et/ou de sortie du premier fluide.

Le dispositif conforme à l'invention comprend aussi, par exemple, une boîte collectrice commune 52 pour la circulation du second fluide, reliée aux boîtes collectrices 10 des modules par leurs tubulures 13. Un joint 53, par exemple élastomère, est prévu pour assurer l'étanchéité de la circulation de fluide entre les tubulures 13 et la boîte collectrice commune 52. Cette dernière est munie de cloisons (non visibles) permettant la circulation du second fluide en série d'un module à l'autre. Lesdites cloisons sont situées dans la boîte collectrice 52, par exemple, au droit d'un espace prévu entre deux tubulures 13 d'un même module.

D'autres configurations de boîtes collectrices pour le second fluide pourront bien sûr être prévues, notamment permettant une circulation du second fluide en parallèle entre les modules.

## Revendications

1. Module thermo électrique comprenant une pluralité de tubes (1) de circulation d'un premier fluide, s'étendant parallèlement les uns aux autres, en un rang (21), et une pluralité de tubes (2) de circulation d'un second fluide s'étendant parallèlement les uns aux autres, en deux rangs (22), situés de part et d'autre du rang (21) de tubes (1) de circulation du premier fluide, ledit module comprenant en outre une pluralité d'éléments (3), dits thermo électriques, permettant de créer un courant électrique à partir d'un gradient de température appliqué entre deux de leurs faces (4a, 4b), dites faces de contact, prévues au contact desdits tubes (1,2) **caractérisé par** lesdits éléments thermo électriques (3) étant répartis en deux nappes (31, 32), une première nappe (31) entre lesdits tubes (1) de circulation dudit premier fluide et l'un des rangs (22) de tubes (2) de circulation dudit second fluide et un seconde nappe (32) entre les tubes (1) de circulation dudit premier fluide et l'autre des rangs (22) de tubes (2) de circulation dudit second fluide, ledit module comprenant également des moyens de compression prenant appui sur chacun des rangs (22) de tubes de circulation du second fluide pour les appliquer en direction du rang (21) de tubes de circulation du premier fluide.

2. Module selon la revendication 1 dans lequel les tubes (1) de circulation du premier fluide sont configurés pour la circulation d'un fluide, dit chaud, et les tubes (2) de circulation du second fluide sont configurés pour la circulation d'un fluide, dit froid, présentant une température inférieure à la température du premier fluide.

3. Module selon l'une quelconque des revendications 1 ou 2 dans lequel les tubes (1) de circulation du premier fluide s'étendent longitudinalement dans une direction sécante, notamment orthogonale, à la direction dans laquelle les tubes (2) de circulation du second fluide s'étendent longitudinalement de façon à définir des zones d'intersection des tubes (1, 2) au niveau desquelles lesdits éléments thermo électriques (3) sont prévus.

4. Module selon la revendication 3 dans lequel les tubes de circulation (1, 2) sont distant les uns des autres dans une direction orthogonale à leur direction d'extension.

5. Module selon l'une quelconque des revendications 3 ou 4 dans lequel les moyens de compression comprennent des tiges de serrage (15) et dans lequel les tubes (1) de circulation du premier fluide et les tubes (2) de circulation du second fluide sont configurés pour laisser des passages pour lesdites tiges de serrage (15) entre lesdites zones d'intersection.

6. Module selon la revendication 5 dans lequel les moyens de compression comprennent en outre des plaques (17), munis de trous (18) de passage des tiges de serrage (15), lesdites tiges de serrage (15) permettant d'appliquer les plaques (17) contre les tubes (2) de circulation du second fluide.

7. Module selon l'une quelconque des revendications précédentes dans lequel lesdits éléments thermo électriques (3) sont répartis par groupe (4) distants les uns des autres selon ladite direction d'extension des tubes (1, 2) de circulation.

8. Module selon l'une quelconque des revendications précédentes dans lequel lesdits tubes de circulation (1, 2) sont plats.

9. Module selon l'une quelconques des revendications précédentes comprenant en outre une plaque collectrice (8) reliant une extrémité desdits tubes de circulation (1) du premier fluide.

10. Module selon l'une quelconque des revendications précédentes comprenant une boîte collectrice (10) en communication de fluide avec une extrémité desdits tubes de circulation (2) du second fluide.

11. Module selon l'une quelconque des revendications précédentes dans lequel les tubes de l'un, dit premier, des rangs de tubes (2) de circulation du second fluide sont liés aux tubes (2) de l'autre, dit second, rang de tubes (2) de circulation du second fluide pour permettre une circulation du second fluide en série de chacun des tubes (2) de circulation du second fluide du premier rang avec un des tubes (2) de circulation du second fluide du second rang.

12. Dispositif thermo électrique, comprenant une pluralité de modules selon l'une quelconque des revendications précédentes superposés les uns aux autres, selon une direction, dite d'empilement.

13. Dispositif selon la revendication 12 dans lequel les moyens de compressions de chacun des modules sont situés en vis-à-vis des moyens de compression des modules voisins.

14. Dispositif selon l'une quelconque des revendications 12 ou 13 comprenant une plaque collectrice (40), dite commune, en communication de fluide avec les tubes (1) de circulation du premier fluide, à l'une de leur extrémité, ladite plaque (40) étant configurée pour assurer un accrochage des modules entre eux.

15. Dispositif selon la revendication 14 comprenant une goulotte (44) de raccordement de la plaque collectrice commune (40) à un conduit (45) de circulation du premier fluide.

## Patentansprüche

1. Thermoelektrisches Modul, das eine Vielzahl von Umlaufrohren (1) eines ersten Fluids, die sich parallel zueinander in einer Reihe (21) erstrecken, und eine Vielzahl von Umlaufrohren (2) eines zweiten Fluids enthält, die sich parallel zueinander in zwei Reihen (22) erstrecken, die sich zu beiden Seiten der Reihe (21) von Umlaufrohren (1) des ersten Fluids befinden, wobei das Modul außerdem eine Vielzahl von so genannten thermoelektrischen Elementen (3) enthält, die es ermöglichen, ausgehend von einem zwischen zwei ihrer Kontaktseiten genannten Seiten (4a, 4b), die in Kontakt mit den Rohren (1, 2) vorgesehen sind, angewendeten Temperaturgradienten einen elektrischen Strom zu erzeugen, **dadurch gekennzeichnet, dass** die thermoelektrischen Elemente (3) in zwei Lagen (31, 32) verteilt sind, einer ersten Lage (31) zwischen den Umlaufrohren (1) des ersten Fluids und einer der Reihen (22) von Umlaufrohren (2) des zweiten Fluids, und einer zweiten Lage (32) zwischen den Umlaufrohren (1) des ersten Fluids und der anderen der Reihen (22) von Umlaufrohren (2) des zweiten Fluids, wobei das Modul ebenfalls Komprimierungseinrichtungen enthält, die sich auf jede der Reihen (22) von Umlaufrohren des zweiten Fluids auflegen, um sie in Richtung der Reihe (21) von Umlaufrohren des ersten Fluids anzulegen.

2. Modul nach Anspruch 1, wobei die Umlaufrohre (1) des ersten Fluids für den Umlauf eines so genannten warmen Fluids und die Umlaufrohre (2) des zweiten Fluids für den Umlauf eines so genannten kalten Fluids konfiguriert sind, das eine niedrigere Temperatur als das erste Fluid hat.

3. Modul nach einem der Ansprüche 1 oder 2, wobei die Umlaufrohre (1) des ersten Fluids sich längs in einer schneidenden, insbesondere orthogonalen Richtung zu der Richtung erstrecken, in der die Umlaufrohre (2) des zweiten Fluids sich längs erstrecken, um Kreuzungsabschnitte der Rohre (1, 2) zu definieren, in deren Bereich die thermoelektrischen Elemente (3) vorgesehen sind.

4. Modul nach Anspruch 3, wobei die Umlaufrohre (1, 2) in einer Richtung orthogonal zu ihrer Ausdehnungsrichtung einen Abstand zueinander haben.

5. Modul nach einem der Ansprüche 3 oder 4, wobei die Komprimierungseinrichtungen Spannstangen (15) enthalten, und wobei die Umlaufrohre (1) des ersten Fluids und die Umlaufrohre (2) des zweiten Fluids konfiguriert sind, Durchgänge für die Spannstangen (15) zwischen den Kreuzungszonen frei zu lassen.

6. Modul nach Anspruch 5, wobei die Komprimierungseinrichtungen außerdem Platten (17) enthalten, die mit Durchgangslöchern (18) für die Spannstangen (15) versehen sind, wobei die Spannstangen (15) es ermöglichen, die Platten (17) gegen die Umlaufrohre (2) des zweiten Fluids anzulegen.

7. Modul nach einem der vorhergehenden Ansprüche, wobei die thermoelektrischen Elemente (3) gruppenweise (4) gemäß der Ausdehnungsrichtung der Umlaufrohre (1, 2) voneinander entfernt verteilt sind.

8. Modul nach einem der vorhergehenden Ansprüche, wobei die Umlaufrohre (1, 2) flach sind.

9. Modul nach einem der vorhergehenden Ansprüche, das außerdem eine Sammelplatte (8) enthält, die ein Ende der Umlaufrohre (1) des ersten Fluids verbindet.

10. Modul nach einem der vorhergehenden Ansprüche, das einen Sammelbehälter (10) in Fluidverbindung mit einem Ende der Umlaufrohre (2) des zweiten Fluids enthält.

11. Modul nach einem der vorhergehenden Ansprüche, wobei die Rohre der einen so genannten ersten Reihe von Umlaufrohren (2) des zweiten Fluids mit den Rohren (2) der anderen so genannten zweiten Reihe von Umlaufrohren (2) des zweiten Fluids verbunden sind, um einen Umlauf des zweiten Fluids in Reihe jedes der Umlaufrohre (2) des zweiten Fluids der ersten Reihe mit einem der Umlaufrohre (2) des zweiten Fluids der zweiten Reihe zu ermöglichen.

12. Thermoelektrische Vorrichtung, die eine Vielzahl von Modulen nach einem der vorhergehenden Ansprüche enthält, die gemäß einer so genannten Schichtungsrichtung übereinander gelagert sind.

13. Vorrichtung nach Anspruch 12, wobei die Komprimierungseinrichtungen jedes der Module sich gegenüber den Komprimierungseinrichtungen der benachbarten Module befinden.

14. Vorrichtung nach einem der Ansprüche 12 oder 13, die eine so genannte gemeinsame Sammelplatte (40) in Fluidverbindung mit den Umlaufrohren (1) des ersten Fluids an einem ihrer Enden enthält, wobei die Platte (40) konfiguriert ist, eine Befestigung der Module aneinander zu gewährleisten.

15. Vorrichtung nach Anspruch 14, die eine Anschlussstutzen (44) der gemeinsamen Sammelplatte (40) an einen Umlaufkanal (45) des ersten Fluids enthält.

## Claims

1. Thermoelectric module comprising a plurality of tubes (1) for circulating a first fluid, extending parallel to one another, in a row (21), and a plurality of tubes (2) for circulating a second fluid extending parallel to one another, in two rows (22), situated on either side of the row (21) of tubes (1) for circulating the first fluid, said module further comprising a plurality of so-called thermoelectric elements (3) making it possible to create an electric current from a temperature gradient applied between two of their faces (4a, 4b), called contact faces, provided in contact with said tubes (1, 2), **characterized by** said thermoelectric elements (3) being distributed in two sheets (31, 32), a first sheet (31) between said tubes (1) for circulating said first fluid and one of the rows (22) of tubes (2) for circulating said second fluid and a second sheet (32) between the tubes (1) for circulating said first fluid and the other of the rows (22) of tubes (2) for circulating said second fluid, said module also comprising compression means bearing on each of the rows (22) of tubes for circulating the second fluid to press them towards the row (21) of tubes for circulating the first fluid.

2. Module according to Claim 1, in which the tubes (1) for circulating the first fluid are configured to circulate a so-called hot fluid, and the tubes (2) for circulating the second fluid are configured to circulate a so-called cold fluid, exhibiting a temperature lower than the temperature of the first fluid.

3. Module according to either one of Claims 1 and 2, in which the tubes (1) for circulating the first fluid extend longitudinally in a direction that is secant, notably orthogonal, to the direction in which the tubes (2) for circulating the second fluid extend longitudinally so as to define areas of intersection of the tubes (1, 2) at which said thermoelectric elements (3) are provided.

4. Module according to Claim 3, in which the circulation tubes (1, 2) are remote from one another in a direction orthogonal to their direction of extension.

5. Module according to either one of Claims 3 and 4, in which the compression means comprise clamping rods (15) and in which the tubes (1) for circulating the first fluid and the tubes (2) for circulating the second fluid are configured to leave passages for said clamping rods (15) between said areas of intersection.

6. Module according to Claim 5, in which the compression means further comprise plates (17), provided with holes (18) for the passage of the clamping rods (15), said clamping rods (15) making it possible to press the plates (17) against the tubes (2) for circulating the second fluid.

7. Module according to any one of the preceding claims, in which said thermoelectric elements (3) are distributed in groups (4) remote from one another in said direction of extension of the circulation tubes (1, 2).

8. Module according to any one of the preceding claims, in which said circulation tubes (1, 2) are flat.

9. Module according to any one of the preceding claims, further comprising a manifold plate (8) linking one end of said tubes (1) for circulating the first fluid.

10. Module according to any one of the preceding claims, comprising a manifold box (10) fluidically connected with an end of said tubes (2) for circulating the second fluid.

11. Module according to any one of the preceding claims, in which the tubes of one, called first, of the rows of tubes (2) for circulating the second fluid are linked to the tubes (2) of the other, called second, row of tubes (2) for circulating the second fluid to allow a circulation of the second fluid in series from each of the tubes (2) for circulating the second fluid of the first row with one of the tubes (2) for circulating the second fluid of the second row.

12. Thermoelectric device, comprising a plurality of modules according to any one of the preceding claims, superposed on one another, in a so-called stacking direction.

13. Device according to Claim 12, in which the compression means of each of the modules are situated facing compression means of the neighbouring modules.

14. Device according to either one of Claims 12 and 13, comprising a so-called common manifold plate (40), fluidically connected with the tubes (1) for circulating the first fluid, at one of their ends, said plate (40) being configured to ensure an attachment of the modules to one another.

15. Device according to Claim 14, comprising a spout (44) for coupling the common manifold plate (40) to a duct (45) for circulating the first fluid.
